# EUROPÄISCHE PATENTSCHRIFT

(11) **EP 1 105 555 B1**
(45) Veröffentlichungstag und Bekanntmachung des Hinweises auf die Patenterteilung: **24.04.2002**
(21) Anmeldenummer: 99942774.3
(22) Anmeldetag: 01.07.1999
(51) Int. Cl.: C30B 23/00, C30B 29/36

(54) **VERFAHREN ZUR ZÜCHTUNG VON SiC-EINKRISTALLEN**
METHOD FOR GROWING SiC MONOCRYSTALS
PROCEDE DE PRODUCTION DE MONOCRISTAUX DE SiC

(30) Priorität: 13.07.1998 DE 19831362
(43) Veröffentlichungstag der Anmeldung: 13.06.2001
(73) Patentinhaber: SIEMENS AKTIENGESELLSCHAFT, 80333 München (DE)
(72) Erfinder: STEIN, Rene, D-91341 Röttenbach (DE); KUHN, Harald, D-91056 Erlangen (DE); VOELKL, Johannes, D-91056 Erlangen (DE)
(86) Internationale Anmeldenummer: DE9901966
(87) Internationale Veröffentlichungsnummer: WO0004211

(56) Entgegenhaltungen:
- EP-A- 0 403 887
- PATENT ABSTRACTS OF JAPAN vol. 1995, no. 02, 31. März 1995 (1995-03-31) & JP 06 316499 A (SHARP CORP), 15. November 1994 (1994-11-15) in der Anmeldung erwähnt
- HOFMANN D ET AL: "SiC-bulk growth by physical-vapor transport and its global modelling" JOURNAL OF CRYSTAL GROWTH,NL,NORTH-HOLLAND PUBLISHING CO. AMSTERDAM, Bd. 174, Nr. 1-4, Seite 669-674 XP004083867 ISSN: 0022-0248 in der Anmeldung erwähnt
- SPENCER M G ET AL: "Improvement in the growth rate of cubic silicon carbide bulk single crystals grown by the sublimation method" JOURNAL OF CRYSTAL GROWTH,NL,NORTH-HOLLAND PUBLISHING CO. AMSTERDAM, Bd. 174, Nr. 1-4, Seite 662-668 XP004083866 ISSN: 0022-0248 in der Anmeldung erwähnt

## Beschreibung

Die Erfindung betrifft ein Verfahren zur Züchtung von mindestens einem Siliciumcarbid(SiC)-Einkristall durch Sublimation eines SiC-Quellmaterials.

Das Sublimieren von technischem SiC in Pulverform und Aufwachsen dieses SiC's in der Gasphase auf einem einkristallinen SiC-Keimkristall ist ein aus der *DE 32 30 727 C2* bekanntes Verfahren zur Herstellung eines SiC-Einkristalls. Das bei der Sublimation entstehende Gasgemisch besteht hauptsächlich aus den Komponenten Si, Si₂C, SiC₂ und SiC. Dieses Gasgemisch wird im folgenden auch mit "SiC in der Gasphase" bezeichnet. Als Quellmaterial kommt üblicherweise technisches Siliciumcarbid in körniger Form und großer Reinheit zum Einsatz, wobei das Siliciumcarbid vorzugsweise eine Körnung von etwa 200 bis 300 µm aufweist. Dieses SiC-Quellmaterial wird vor dem Züchtungsprozeß des SiC-Einkristalls hergestellt und als fertiges Quellmaterial in eine Züchtungskammer eingebracht.

Der Aufsatz *"SiC-bulk growth by physical-vapor transport and its global modelling", D.Hofmann et al., Journal of Crystal Growth, Vol. 174, 1979, Seiten 669 bis 674* gibt ein Verfahren zur Synthese eines als Quellmaterial verwendeten SiC-Pulvers aus elementarem Silicium(Si)-Granulat und Kohlenstoff(C)-Pulver an.

Ein weiteres Verfahren zur Herstellung des Quellmaterials in Form von SiC-Pulver ist aus dem Aufsatz *"Improvement in the growth rate of cubic silicon carbide bulk single crystals grown by the sublimation method", H.N.Jayatirtha et al., Journal of Crystal Growth, Vol. 174, 1997, Seiten 662 bis 668* bekannt. Dabei reagieren hochreines Silicium und hochreiner Kohlenstoff bei 1800°C insgesamt drei Stunden lang miteinander. Anschließend wird das Pulver aus dem Reaktionsofen entnommen und weiteren Behandlungsschritten unterzogen. Insbesondere wird eine dreistündige Oxidation bei 1200°C durchgeführt, um überschüssigen Kohlenstoff zu entfernen. Anschließend wird ein Atzschritt durchgeführt, um durch die Oxidation entstandene Spuren von SiO₂ zu beseitigen.

Alle vorstehend angesprochenen Verfahren zur Herstellung des Quellmaterials in Form von SiC-Pulver haben gemeinsam, daß die Herstellung des SiC-Pulvers und die eigentliche Züchtung des SiC-Einkristalls voneinander unabhängig durchgeführte Einzelprozesse darstellen.

Demgegenüber gibt die *JP 6-316 499* A ein Verfahren zur Herstellung eines SiC-Einkristalls an, das in einem vorangestellten Prozeßschritt auch die Bildung des SiC-Quellmaterials aus Silicium und Kohlenstoff als integralen Bestandteil des Züchtungsprozesses beinhaltet. Der Züchtungsvorgang im engeren Sinne findet durch Sublimation des im vorangegangenen Prozeßschritt hergestellten SiC-Quellmaterials und durch Abscheidung des SiC's in der Gasphase auf einem SiC-Keimkristall statt. Als Ausgangsmaterial für die Herstellung des SiC-Quellmaterials dienen Kohlenstoff in Form eines Graphitblocks oder Kohlenstoff(C)-Pulvers mit einem Korndurchmesser unter 10 µm sowie körniges Silicium mit einem Korndurchmesser zwischen 2 und 5 mm. Dabei wird der Korndurchmesser des Siliciums als unkritische Größe angegeben, die gegebenenfalls auch Werte außerhalb des genannten Durchmesserbereichs annehmen kann. Für das eingesetzte C-Pulver wird jedoch ausdrücklich angegeben, daß bei einer Korngröße von über 10 µm nur die Oberfläche des C-Pulvers mit Silicium reagiert und somit kein geeignetes SiC-Quellmaterial gebildet wird.

In einer zweiten Ausführungsform, bei der anstelle des C-Pulvers ein Graphitblock aus porösem Graphit mit einem spezifischen Gewicht von 0,5 g/cm³ eingesetzt wird, findet der Herstellungsprozeß des SiC-Quellmaterials und der Züchtungsprozeß des SiC-Einkristalls nicht innerhalb eines einzigen Prozeßablaufs statt. Die Züchtungskammer wird nach Herstellung des SiC-Quellmaterials noch einmal geöffnet, um den SiC-Keimkristall einzubringen. Erst im Anschluß daran wird die eigentliche Züchtung gestartet. Das spezifische Gewicht des verwendeten porösen Graphits kann auch andere Werte als 0,5 g/cm³ annehmen. Als obere Grenze wird ein spezifisches Gewicht von 1,0 g/cm³ angegeben, da bei höheren Werten SiC-Quellmaterial nicht mehr in ausreichender Menge gebildet wird.

Die Prozeßbedingungen während der Herstellung des SiC-Quellmaterials liegen bei einer Temperatur im Bereich zwischen 1150°C und 1800°C sowie bei einem Druck von kleiner als 200 Torr, entsprechend etwa 266 mbar.

Bei der Verwendung von C-Pulver mit einem Korndurchmesser von kleiner als 10 µm kann es nun im Laufe der während der Herstellung des SiC-Quellmaterials stattfindenden Reaktion sehr leicht zu einer Aufwirbelung von Partikeln, insbesondere des C-Pulvers, kommen. Dadurch bilden sich Ablagerungen auf dem SiC-Keimkristall, die die Qualität der im Anschluß durchzuführenden Züchtung beeinträchtigt.

Die Aufgabe der Erfindung besteht nun darin, ein Verfahren der eingangs bezeichneten Art anzugeben, das die beim Stand der Technik auftretende Aufwirbelung von C-Pulver vermeidet und somit zu einer insgesamt verbesserten Qualität des gezüchteten SiC-Einkristalls führt.

Zur Lösung der Aufgabe wird ein Verfahren entsprechend den Merkmalen des unabhängigen Patentanspruchs 1 angegeben.

Bei dem erfindungsgemäßen Verfahren zur Züchtung von mindestens einem Siliciumcarbid-Einkristall durch Sublimation eines SiC-Quellmaterials handelt es sich um ein Verfahren, bei welchem
a) Silizium, Kohlenstoff und ein SiC-Keimkristall in eine Züchtungskammer eingebracht werden,
b) das SiC-Quellmaterial in einem der eigentlichen Züchtung vorgeschalteten Synthetisierungsschritt aus dem Silizium und dem Kohlenstoff hergestellt wird, und
c) die Züchtung des SiC-Einkristalls unmittelbar nach dem Synthetisierungsschritt durchgeführt wird, wobei
d) als Kohlenstoff ein C-Pulver mit einem mittleren Korndurchmesser der Pulverkörner von größer als 10 um verwendet wird.

Die Erfindung beruht dabei auf der Erkenntnis, daß entgegen der üblichen Vorgehensweise der Fachwelt, die durch die mit der JP 6-316 499 A offenbarten technischen Lehre bestimmt ist, die Verwendung von C-Pulver mit einem größeren mittleren Korndurchmesser als 10 µm dennoch möglich und sogar vorteilhaft ist. Aufgrund der größeren Geometrie und dem folglich höheren Gewicht wird durch diese Maßnahme die unerwünschte Aufwirbelung des C-Pulvers während der Herstellung des SiC-Quellmaterials vermieden. Es kommt somit während dieses Prozeßschritts zu keinem unerwünschten Niederschlag auf dem SiC-Keimkristall, der sich bereits während der Herstellung des SiC-Quellmaterials in der Züchtungskammer befindet. Überraschend ist insbesondere die Erkenntnis, daß C-Pulver auch mit einem mittleren Korndurchmesser größer als 10 µm mit dem Silicium so gut reagiert, daß ein SiC-Quellmaterial mit hoher und für die nachfolgende Züchtung des SiC-Einkristalls bestens geeigneter Qualität resultiert.

Als Kohlenstoff kann dabei sowohl synthetischer als auch natürlicher Kohlenstoff verwendet werden.

Besondere Ausgestaltungen und Weiterbildungen des Verfahrens nach der Erfindung ergeben sich aus den abhängigen Unteransprüchen.

In einer ersten bevorzugten Ausgestaltung weist das C-Pulver einen mittleren Korndurchmesser von größer als 20 um und insbesondere von größer als 30 µm auf. Die unerwünschte Aufwirbelung des C-Pulvers wird um so stärker unterdrückt, je größer der mittlere Korndurchmesser ist.

Vorteilhaft ist weiterhin eine Ausführungsform, bei der das C-Pulver mit einer Korngröße, die kleiner als 200 µm und vorzugsweise kleiner als 80 µm, gewählt wird. Liegt die Korngröße unter diesen angegebenen Obergrenzen, so reagiert noch der gesamte Kohlenstoff innerhalb des Pulverkorns mit dem Silicium. Wird dagegen ein C-Pulver mit größerem mittleren Korndurchmesser vorgesehen, so kommt es tatsächlich nur zu einer Reaktion des Kohlenstoffs an der Oberfläche des Pulverkorns mit dem Silicium. Dadurch ergibt sich in dem SiC-Quellmaterial ein unerwünschter Überschußanteil von nicht gebundenen Kohlenstoff- und Siliciumatomen.

Eine andere vorteilhafte Ausführungsform des Verfahrens sieht vor, für den Kohlenstoff in dem C-Pulver eine Kohlenstoffsorte zu verwenden, bei dem die Reaktion mit dem Silicium zu dem SiC-Quellmaterial endotherm oder zumindest ohne wesentliche Freisetzung von Energie abläuft. Eine unerwünschte Aufwirbelung von Partikeln, in diesem Fall sowohl von Kohlenstoffoder auch Siliciumpartikeln, kann nämlich auch durch eine exotherm ablaufende Reaktion des Siliciums und des Kohlenstoffs hervorgerufen werden. Die in diesem Fall freigesetzte Reaktionsenergie führt zu der unerwünschten Aufwirbelung mit den oben beschriebenen nachteiligen Auswirkungen. Bei den angegebenen bevorzugten Kohlenstoffsorten findet die Reaktion mit dem Silicium insbesondere ohne Volumenausdehnung statt. Eine thermoanalytische Untersuchung der Reaktion zeigt, daß Energie aufgenommen wird oder Energie nur in so geringem Maße freigesetzt wird, daß sie zu niedrig für die Aufwirbelung von Partikeln ist.

Im Hinblick auf eine möglichst ohne Freisetzung von Energie ablaufende Reaktion des C-Pulvers mit dem Silicium ist insbesondere eine Variante vorteilhaft, bei der eine Kohlenstoffsorte, deren Pulverkörner sich aus einer Vielzahl einzelner Kristallite zusammensetzen, verwendet wird. Bevorzugt enthält dabei ein Pulverkorn mindestens 10 bis 20 Kristallite. Die polykristalline Struktur der einzelnen Körner trägt dann maßgeblich zu einer im wesentlichen ohne Energieabgabe ablaufenden Gesamtreaktion bei. Beim Aufheizen schmilzt zunächst das Silicium. Vorher findet praktisch keine Reaktion zwischen den beiden Elementen statt. Das Aufschmelzen ist endotherm. Mit dem Einsetzen des Aufschmelzens startet auch die an sich exotherme Reaktion der SiC-Synthese. Dank der polykristallinen Struktur der C-Pulverkörner läuft diese Synthesereaktion nicht nur an der Kornoberfläche, sondern auch im Korninneren ab. Da das endotherme Aufschmelzen und die exotherme Synthesereaktion weitgehend parallel stattfinden, ergibt sich eine praktisch neutrale Energiebilanz. Bei einer Kohlenstoffsorte, deren Pulverkörner nur wenige Kristallite enthalten, laufen beide Teilreaktionen dagegen eher sukzessiv ab. Dann kann es nicht zu der vorteilhaften Energiekompensation kommen, und die während der Synthese freiwerdende Energie führt zu einer unerwünschten Aufwirbelung von Partikeln.

Bevorzugt ist auch eine Ausführungsform, bei der das Silicium in Form eines Silicium(Si)-Pulvers gewählt wird. Der maximale mittlere Korndurchmesser des Si-Pulvers beträgt dabei einen Millimeter. Bevorzugt liegt der mittlere Korndurchmesser in einem Bereich zwischen 100 µm und 400 µm. Im Gegensatz zu der Korngröße des C-Pulvers ist der mittlere Korndurchmesser des Si-Pulvers ein weit weniger kritischer Parameter. Die Reaktion zwischen Silicium und Kohlenstoff zu dem SiC-Quellmaterial findet bevorzugt bei Temperaturen über 1400°C statt. Da Silicium bei diesen Temperaturen nicht mehr in der ursprünglich eingebrachten Pulverform sondern bereits in geschmolzener Form vorliegt, kann für das Si-Pulver ein wesentlich höherer mittlerer Korndurchmesser gewählt werden als für das C-Pulver. Das durch den Schmelzvorgang flüssig gewordene Silicium tränkt den Kohlenstoff, so daß die Vermischung zwischen Silicium und Kohlenstoff praktisch ausschließlich durch den mittleren Korndurchmesser des C-Pulvers bestimmt wird. Der obere Wert für den mittleren Korndurchmesser des Si-Pulvers wird dadurch bestimmt, daß bei zu großen mittleren Korndurchmessern der Schmelzvorgang zu lange dauert und der Kohlenstoff somit nicht optimal durch aufgeschmolzenes Silicium getränkt wird.

Um eine für die Reaktion zwischen Silicium und Kohlenstoff möglichst homogene Durchmischung zu erreichen, werden das Si-Pulver und das C-Pulver gemäß einer vorteilhaften Ausgestaltung intensiv miteinander vermischt und dann als möglichst homogenes Gemisch in die Züchtungskammer eingebracht. Durch die intensive Vermischung wird die Reaktionsausbeute bei der Herstellung des SiC-Quellmaterials verbessert.

In einer bevorzugten Ausführungsvariante wird die Züchtungskammer in Vorbereitung auf den Herstellungsprozeß des SiC-Quellmaterials bei einer Temperatur zwischen 1000°C und 1300°C mehrere Stunden lang evakuiert, bis ein Druck von kleiner oder gleich 10⁻⁴ mbar erreicht ist. Nach der Evakuierung wird die Züchtungskammer mit einem Inertgas, insbesondere mit Argon (Ar), Helium (He) oder Wasserstoff (H₂), befüllt. Dabei wird ein Inertgasdruck in einem Bereich zwischen 100 und 1000 mbar eingestellt.

Vorteilhaft ist auch eine Ausführungsvariante, bei der das Silicium und der Kohlenstoff auf eine Synthesetemperatur von mindestens 1200°C und höchstens 1900°C aufgeheizt werden. Besonders vorteilhaft ist eine Synthesetemperatur im Bereich zwischen 1400 und 1600°C, da in diesem Temperaturbereich einerseits das Silicium bereits aufgeschmolzen ist und den Kohlenstoff durchtränkt und andererseits die Reaktion zu dem SiC-Quellmaterial mit guter Ausbeute stattfindet. Die Synthesetemperatur wird für eine Zeitdauer von höchstens drei Stunden, insbesondere von nur höchstens einer Stunde gehalten, so daß das in die Züchtungskammer eingebrachte Silicium und der ebenfalls eingebrachte Kohlenstoff möglichst vollständig miteinander reagieren und das gewünschte SiC-Quellmaterial bilden.

Ein besonderer Vorteil des Verfahrens liegt darin, nach der durchgeführten Herstellung des SiC-Quellmaterials die Züchtungskammer nicht mehr abzukühlen und das SiC-Quellmaterial gegebenenfalls aus der Züchtungskammer zu entnehmen, wodurch unerwünschte Verunreinigungen in das SiC-Quellmaterial eingebracht werden könnten. Deshalb sieht eine vorteilhafte Ausführungsvariante vor, die Züchtungskammer ausgehend von den Bedingungen für die Herstellung des SiC-Quellmaterials auf die Züchtungsbedingungen für den SiC-Einkristall zu bringen. Dies bedeutet insbesondere eine Anhebung der Temperatur des SiC-Quellmaterials von der Synthesetemperatur auf eine Temperatur zwischen 2100°C und 2500°C. Außerdem wird gleichzeitig auch der während der Herstellung des SiC-Quellmaterials herrschende Gesamtdruck auf höchsten 30 mbar reduziert. Bei diesen Bedingungen wird SiC aus dem SiC-Quellmaterial sublimiert und schlägt sich dann aus der Gasphase auf dem SiC-Keimkristall nieder. Um einen entsprechenden Materialtransport des SiC's in der Gasphase zu gewährleisten, wird ein Temperaturgradient zwischen dem SiC-Quellmaterial und dem SiC-Keimkristall bzw. dem sich bildenden SiC-Einkristall hergestellt.

Durch entsprechend gewählte Orientierungen des SiC-Keimkristalls kann ein SiC-Einkristall eines bestimmten Polytyps gezüchtet werden. In vorteilhaften Ausführungsformen wird deshalb vorgesehen, den SiC-Keimkristall so in der Züchtungskammer anzubringen, daß der SiC-Einkristall auf einer C-Seite oder einer Si-Seite des SiC-Keimkristalls in Richtung einer polaren Achse aufwächst. Das Wachstum auf der C-Seite liefert dabei einen 4H-SiC-Einkristall, das Wachstum auf einer Si-Seite dagegen einen 6H-SiC-Einkristall.

Bevorzugte Ausführungsbeispiele werden nunmehr anhand der Zeichnung näher erläutert. Zur Verdeutlichung ist die Zeichnung nicht maßstäblich ausgeführt und gewisse Merkmale sind schematisiert dargestellt. Im einzelnen zeigen:
- Figur 1: eine Züchtungskammer vor Prozeßbeginn, in die ein SiC-Keimkristall sowie Si- und C-Pulver eingebracht worden sind, und
- Figur 2: die Züchtungskammer von Figur 1 nach dem Prozeßschritt zur Herstellung des SiC-Quellmaterials und während des Prozeßschritts zur Züchtung des SiCEinkristalls.

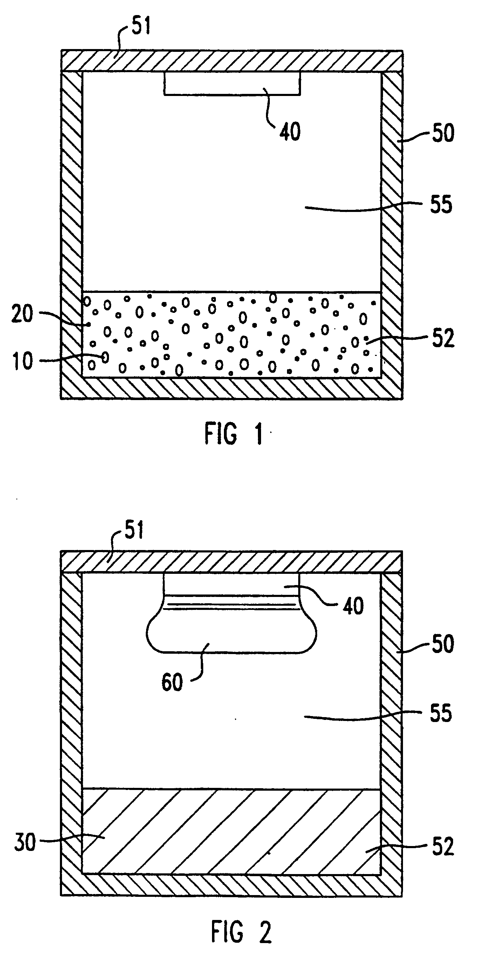

Einander entsprechende Teile sind in den Figuren 1 und 2 mit denselben Bezugszeichen versehen.

In Figur 1 ist eine Züchtungskammer 50 dargestellt, die zur Züchtung eines SiC-Keimkristalls dient. Im Unterschied zu bisher gebräuchlichen Züchtungsverfahren wird in die Züchtungskammer 50 als Ausgangssubstanz für die Züchtung nicht vorher hergestelltes SiC-Quellmaterial eingebracht sondern ein Gemisch aus einem Si-Pulver 10 und einem C-Pulver 20. Neben diesem Pulvergemisch wird auch bereits ein SiC-Keimkristall 40 in die Züchtungskammer eingebracht. Das Gemisch aus dem Si-Pulver 10 und dem C-Pulver 20 und der SiC-Keimkristall 40 sind durch einen freien Zwischenraum 55 vonein ander getrennt. Das Gemisch aus dem Si-Pulver 10 und dem C-Pulver 20 befindet sich in einem unteren Vorratsbereich 52 der Züchtungskammer 50, wohingegen der SiC-Keimkristall 40 an einer oberen Wand 51 der Züchtungskammer 50 angebracht ist.

Der mittlere Korndurchmesser des Si-Pulvers 10 beträgt 200 µm, der mittlere Korndurchmesser des C-Pulvers 20 beträgt 50 µm. Dadurch wird einerseits vermieden, daß das C-Pulver aufgrund zu geringer Masse während der Reaktion zur Herstellung von SiC-Quellmaterial in den freien Zwischenraum 55 und insbesondere auch bis zu dem SiC-Keimkristall 40 aufgewirbelt wird. Andererseits wird durch die gewählten mittleren Korndurchmesser aber auch sichergestellt, daß ein ausreichend homogener Durchmischungsgrad vorliegt, der zu einer guten Ausbeute bei der Herstellung des SiC-Quellmaterials führt. Dazu sind das SiC-Pulver 10 und das C-Pulver 20 vor dem Einbringen in die Züchtungskammer 40 intensiv miteinander vermischt worden.

Die Synthese des SiC-Quellmaterials aus dem Si-Pulver 10 und dem C-Pulver 20 sowie die eigentliche Züchtung eines SiC-Einkristalls sind bei dem vorliegenden Verfahren in einen kontinuierlich durchführbaren Prozeß integriert. Die Synthese des SiC-Quellmaterials findet dabei in einer für die Züchtung ohnehin notwendigen Aufheizphase statt. Diese verlängert sich dadurch nur geringfügig. Dafür spart man einen separaten Prozeß zur Herstellung von SiC-Quellmaterial komplett ein. Der dem eigentlichen Züchtungsprozeßschritt vorangeschaltete Prozeßschritt zur Herstellung des SiC-Quellmaterials läuft dabei folgendermaßen ab:

Die Züchtungskammer 50 wird zunächst auf eine Temperatur von etwa 1200°C aufgeheizt und bei dieser Temperatur mehrere Stunden evakuiert. Sobald auf mindestens 10⁻⁴ mbar evakuiert worden ist, wird Argon in die Züchtungskammer eingeleitet. Der Argon-Gasdruck wird auf einen Wert von 500 mbar eingestellt. Anschließend wird die Züchtungskammer auf eine Synthesetemperatur von 1500°C aufgeheizt. Ab einer Temperatur von ca. 1400°C schmilzt das Si-Pulver 10 und tränkt das C-Pulver 20, wodurch sich eine weiter verbesserte homogene Durchmischung einstellt. Bei der gewählten Synthesetemperatur reagieren der Kohlenstoff und das Silicium miteinander und bilden das SiC-Quellmaterial. Nach einer Verweildauer von ca. einer Stunde auf der Synthesetemperatur von 1500°C, während der die Reaktion zur Bildung des SiC-Quellmaterials abläuft, wird die Züchtungskammer 50 auf Züchtungsbedingung gebracht. Dies bedeutet, daß die Temperatur des hergestellten SiC-Quellmaterials auf 2400°C angehoben wird und gleichzeitig der Gesamtdruck in der Züchtungskammer 50 auf 3 mbar abgesenkt wird. Gleichzeitig wird eine Temperatur an dem SiC-Keimkristall 40 eingestellt, die um bis zu 500°C unter der Temperatur des SiC-Quellmaterials liegt. Aufgrund eines sich somit einstellenden Temperaturgradienten kommt es zu einem Transport des sublimierten SiC's in der Gasphase zu dem SiC-Einkristall 40. Durch Niederschlag des SiC's in der Gasphase auf dem SiC-Keimkristall 40 wächst der SiC-Einkristall auf.

In Figur 2 ist die Züchtungskammer 50 zu einem Zeitpunkt dargestellt, in der die Bildung eines SiC-Einkristalls 60 bereits begonnen hat. SiC-Material das sich hierbei auf dem SiC-Keimkristall 40 bzw. auf dem SiC-Einkristall 60 niederschlägt, entsteht hierbei durch Sublimation eines SiC-Quellmaterials 30. Dieses SiC-Quellmaterial 30 ist entsprechend dem unter Figur 1 beschriebenen vorangegeschalteten ersten Prozeßschritt aus dem Si-Pulver 10 und dem C-Pulver 20 hergestellt worden.

Verglichen mit zwei getrennten ablaufenden Prozessen führt das beschriebene Züchtungsverfahrens mit dem integrierten Prozeßschritt zur Herstellung des SiC-Quallmaterials 30 zu einer erheblichen Zeitersparnis. Diese beträgt bis zu zwölf Stunden. Sie resultiert insbesondere aus der Einsparung einer zusätzlichen Abkühl- und Aufheizphase sowie aus dem Entfallen von Umbaumaßnahmen bzw. des Umfüllens des hergestellten SiC-Quellmaterials 30.

Es versteht sich, daß die in den Figuren 1 und 2 gezeigte Züchtungskammer 50 nur schematisiert dargestellt ist. In nicht gezeigten Ausführungsformen kann die Züchtungskammer 50 deshalb auch einen komplexeren Aufbau aufweisen. Beispielsweise kann der freie Zwischenraum 55 durch konstruktive Maßnahmen so gestaltet sein, daß aus dem SiC-Quellmaterial 30 sublimiertes SiC direkt zu dem SiC-Keimkristall 40 geleitet wird. Die konstruktive Maßnahme kann dabei die Gestalt eines Gaskanals annehmen.

Außerdem wurde das Züchtungsverfahren obenstehend ohne Einschränkung der Allgemeingültigkeit anhand eines Beispiels zur Züchtung eines SiC-Einkristalls beschrieben. Es ist jedoch ohne weiteres möglich, in der Züchtungskammer 50 auch mehrere SiC-Einkristalle 60 herzustellen. Dazu werden beispielsweise mehrere SiC-Keimkristalle 40 in der Züchtungskammer 50 angebracht, auf die dann jeweils ein eigener SiC-Einkristall 60 aufwächst.

## Patentansprüche

1. Verfahren zur Züchtung von mindestens einem Siliciumcarbid (SiC)-Einkristall (60) durch Sublimation eines SiC-Quellmaterials (30), bei dem
a) Silicium (Si), Kohlenstoff (C) und ein SiC-Keimkristall (40) in eine Züchtungskammer (50) eingebracht werden,
b) das SiC-Quellmaterial (30) in einem der eigentlichen Züchtung vorgeschalteten Synthetisierungsschritt aus dem Silicium und dem Kohlenstoff hergestellt wird,
c) die Züchtung des SiC-Einkristalls (60) unmittelbar nach dem Synthetisierungsschritt durchgeführt wird, wobei
d) als Kohlenstoff ein C-Pulver (20) mit einem mittleren Korndurchmesser der Pulverkörner von größer als 10 µm verwendet wird.

2. Verfahren nach Anspruch 1, **dadurch gekennzeichnet, daß** der mittlere Korndurchmesser des C-Pulvers (20) größer als 20 um, insbesondere größer als 30 µm, gewählt wird.

3. Verfahren nach Anspruch 1 oder 2, **dadurch gekennzeichnet, daß** der mittlere Korndurchmesser des C-Pulvers (20) kleiner als 200 µm, insbesondere kleiner als 80 µm, gewählt wird.

4. Verfahren nach einem der vorhergehenden Ansprüche, **dadurch gekennzeichnet, daß** als Kohlenstoff eine Kohlenstoffsorte vorgesehen wird, deren Reaktion mit Silicium zu dem SiC-Quellmaterial (30) im wesentlichen ohne Freisetzung von Energie abläuft.

5. Verfahren nach Anspruch 4, **dadurch gekennzeichnet, daß** als Kohlenstoff ein C-Pulver (20) vorgesehen wird, dessen Pulverkörner sich aus mindestens 10 einzelnen Kristalliten zusammensetzen.

6. Verfahren nach einem der vorhergehenden Ansprüche, **dadurch gekennzeichnet, daß** als Silicium ein Si-Pulver (10) mit einem mittleren Korndurchmesser von höchstens 1 mm, insbesondere mit einem mittleren Korndurchmesser zwischen 100 µm und 400 µm, vorgesehen wird.

7. Verfahren nach Anspruch 6, **dadurch gekennzeichnet, daß** das Si-Pulver (10) und das C-Pulver (20) vor Einbringung in die Züchtungskammer (50) zu einem homogenen Gemisch vermischt werden.

8. Verfahren nach einem der vorhergehenden Ansprüche, **dadurch gekennzeichnet, daß** die Züchtungskammer (50) auf 1200°C erhitzt wird und dann bei 1200°C bis auf einen Druck kleiner oder gleich 10⁻⁴ mbar evakuiert wird.

9. Verfahren nach Anspruch 8, **dadurch gekennzeichnet, daß** die Züchtungskammer (50) mit einem Inertgas, insbesondere mit Argon (Ar), Helium (He) oder Wasserstoff (H₂), befüllt wird, und ein Inertgasdruck zwischen 100 und 1000 mbar eingestellt wird.

10. Verfahren nach Anspruch 9, **dadurch gekennzeichnet, daß** das Silicium und der Kohlenstoff auf eine Synthesetemperatur zwischen 1200°C und 1900°C, insbesondere zwischen 1400°C und 1600°C, aufgeheizt werden und für eine Zeitdauer von höchstens drei Stunden, insbesondere von höchstens einer Stunde, während der die Reaktion des Siliciums und des Kohlenstoffs zu dem SiC-Quellmaterial (30) stattfindet, auf etwa dieser Synthesetemperatur gehalten wird.

11. Verfahren nach Anspruch 10, **dadurch gekennzeichnet, daß** die Züchtungskammer (50) ausgehend von der Synthesetemperatur und dem Inertgasdruck auf Züchtungsbedingung gebracht wird, insbesondere das SiC-Quellmaterial (30) auf eine Temperatur zwischen 2100°C und 2500°C erhitzt wird, und ein Gesamtdruck von höchstens 30 mbar eingestellt wird.

12. Verfahren nach einem der vorhergehenden Ansprüche, **dadurch gekennzeichnet, daß** das Silicium und der Kohlenstoff in einen unteren Vorratsbereich (52) der Züchtungskammer (50) eingebracht werden, und der SiC-Keimkristall (40) an einer oberen Wand (51) befestigt wird, so daß sich zwischen dem Silicium und dem Kohlenstoff einerseits und dem SiC-Keimkristall (40) andererseits ein freier Zwischenraum (55) befindet.

13. Verfahren nach einem der vorhergehenden Ansprüche, **dadurch gekennzeichnet, daß** ein 4H-SiC-Einkristall gezüchtet wird, wobei der SiC-Keimkristall (40) so angeordnet wird, daß er eine Wachstumsfläche entsprechend einer C-Seite der Richtung einer polaren Achse aufweist.

14. Verfahren nach einem der Ansprüche 1 bis 12, **dadurch gekennzeichnet, daß** ein 6H-SiC-Einkristall gezüchtet wird, wobei der SiC-Keimkristall (40) so angeordnet wird, daß er eine Wachstumsfläche entsprechend einer Si-Seite der Richtung einer polaren Achse aufweist.

## Claims

1. Method for growing at least one silicon carbide (SiC) single crystal (60) by sublimation of an SiC source material (30), in which
a) silicon (Si), carbon (C) and an SiC seed crystal (40) are introduced into a growing chamber (50),
b) the SiC source material (30) is produced from the silicon and the carbon in a synthesis step which is carried out before the actual growing,
c) the growing of the SiC single crystal (60) is carried out immediately after the synthesis step,
d) the carbon used being a C powder (20) with a mean diameter of the powder grains of greater than 10 µm.

2. Method according to Claim 1, **characterized in that** the mean grain diameter of the C powder (20) is selected to be greater than 20 µm, in particular greater than 30 µm.

3. Method according to Claim 1 or 2, **characterized in that** the mean grain diameter of the C powder (20) is selected to be less than 200 µm, in particular less than 80 µm.

4. Method according to one of the preceding claims, **characterized in that** the carbon provided is a type of carbon which reacts with silicon to form the SiC source material (30) substantially without energy being released.

5. Method according to Claim 4, **characterized in that** the carbon provided is a C powder (20), the grains of which are composed of at least ten individual crystallites.

6. Method according to one of the preceding claims, **characterized in that** the silicon provided is a Si powder (10) with a mean grain diameter of at most 1 mm, in particular with a mean grain diameter of between 100 µm and 400 µm.

7. Method according to Claim 6, **characterized in that** the Si powder (10) and the C powder (20) are mixed to form a homogeneous mixture before being introduced into the growing chamber (50).

8. Method according to one of the preceding claims, **characterized in that** the growing chamber (50) is heated to 1200°C and is then evacuated at 1200°C to a pressure of less than or equal to 10⁻⁴ mbar.

9. Method according to Claim 8, **characterized in that** the growing chamber (50) is filled with an inert gas, in particular with argon (Ar), helium (He) or hydrogen (H₂), and an inert gas pressure of between 100 and 1000 mbar is set.

10. Method according to Claim 9, **characterized in that** the silicon and the carbon are heated to a synthesis temperature of between 1200°C and 1900°C, in particular between 1400°C and 1600°C, and are held at approximately this synthesis temperature for a period of at most three hours, in particular of at most one hour, during which the reaction between the silicon and the carbon to form the SiC source material (30) takes place.

11. Method according to Claim 10, **characterized in that** the growing chamber (50), starting from the synthesis temperature and the inert gas pressure, is brought to growing conditions, in particular the SiC source material (30) is heated to a temperature of between 2100°C and 2500°C, and an overall pressure of at most 30 mbar is set.

12. Method according to one of the preceding claims, **characterized in that** the silicon and the carbon are introduced into a lower storage region (52) in the growing chamber (50), and the SiC seed crystal (40) is attached to an upper wall (51), so that there is a clear space (55) between the silicon and the carbon, on the one hand, and the SiC seed crystal (40), on the other hand.

13. Method according to one of the preceding claims, **characterized in that** a 4H-SiC single crystal is grown, the SiC seed crystal (40) being arranged in such a way that it has a growth surface corresponding to a C side of the direction of a polar axis.

14. Method according to one of Claims 1 to 12, **characterized in that** a 6H-SiC single crystal is grown, the SiC seed crystal (40) being arranged in such a way that it has a growth surface corresponding to an Si side of the direction of a polar axis.

## Revendications

1. Procédé pour faire croître au moins un monocristal (60) de carbure de silicium (SiC) en sublimant une matière (30) source en SiC, qui consiste
a) à mettre du silicium (Si), du carbone (C) et un cristal germe (40) de SiC dans une chambre (50) de croissance,
b) à préparer la matière (30) source de SiC dans un stade de synthèse en amont de la croissance proprement dite, à partir du silicium et du carbone,
c) à faire croître le monocristal (60) de SiC juste après le stade de synthèse,
d) à utiliser comme carbone une poudre (20) de C ayant une granulométrie moyenne des grains de poudre supérieure à 10 µm.

2. Procédé suivant la revendication 1, **caractérisé en ce qu'**il consiste à choisir la granulométrie moyenne de la poudre (20) de C supérieure à 20 µm et notamment supérieure à 30 µm.

3. Procédé suivant la revendication 1 ou 2, **caractérisé en ce qu'**il consiste à choisir la granulométrie moyenne de la poudre (20) de C inférieure à 200 µm et notamment inférieure à 80 µm.

4. Procédé suivant l'une des revendications précédentes, **caractérisé en ce qu'**il consiste à prévoir comme carbone une sorte de carbone dont la réaction sur du silicium pour donner la matière (30) source de SiC se déroule essentiellement sans libération d'énergie.

5. Procédé suivant la revendication 4, **caractérisé en ce qu'**il consiste à prévoir comme carbone une poudre (20) de C dont des grains sont composés d'au moins 10 cristallites individuels.

6. Procédé suivant l'une des revendications précédentes, **caractérisé en ce qu'**il consiste à prévoir comme silicium une poudre (10) de Si d'une granulométrie moyenne d'au plus 1 mm, notamment d'une granulométrie moyenne comprise entre 100 µm et 400 µm.

7. Procédé suivant la revendication 6, **caractérisé en ce qu'**il consiste à mélanger la poudre (10) de Si et la poudre (20) de C avant l'introduction dans la chambre (50) de croissance en un mélange homogène.

8. Procédé suivant l'une des revendications précédentes, **caractérisé en ce qu'**il consiste à chauffer la chambre (50) de mélange à 1200°C et ensuite à la mettre sous vide à 1200°C jusqu'à une pression inférieure ou égale à 10⁻⁴ mbar.

9. Procédé suivant la revendication 8, **caractérisé en ce qu'**il consiste à emplir la chambre (50) de croissance d'un gaz inerte, notamment d'argon (Ar), d'hélium (He) ou d'hydrogène (H₂) et à régler la pression du gaz inerte entre 100 et 1000 mbar.

10. Procédé suivant la revendication 9, **caractérisé en ce qu'**il consiste à chauffer le silicium et le carbone à une température de synthèse comprise entre 1200°C et 1900°C, notamment comprise entre 1400°C et 1600°C et à maintenir à peu près cette température de synthèse pendant une durée d'au plus trois heures, notamment d'au plus une heure, pendant laquelle la réaction du silicium et du carbone pour donner la matière source (30) de SiC a lieu.

11. Procédé suivant la revendication 10, **caractérisé en ce qu'**il consiste à mettre la chambre (50) de croissance en partant de la température de synthèse et de la pression du gaz inerte dans une condition de croissance, notamment en chauffant la matière source (30) de SiC à une température comprise entre 2100°C et 2500°C et en établissant une pression totale d'au plus 30 mbar.

12. Procédé suivant l'une des revendications précédentes, **caractérisé en ce qu'**il consiste à mettre le silicium et le carbone dans une partie (52) inférieure formant réservoir de la chambre (50) de croissance et à fixer le cristal germe (40) de SiC sur une paroi (51) supérieure, de sorte qu'il se trouve entre le silicium et le carbone d'une part et le cristal germe (40) de SiC d'autre part un espace (55) intermédiaire qui est dégagé.

13. Procédé suivant l'une des revendications précédentes, **caractérisé en ce qu'**il consiste à faire croître un monocristal de SiC 4H, le cristal germe (40) de SiC étant disposé de façon à avoir une surface de croissance correspondant à un côté de C de la direction d'un axe polaire.

14. Procédé suivant l'une des revendications 1 à 12, **caractérisé en ce qu'**il consiste à faire croître un monocristal de SiC 6H, le cristal germe (40) de SiC étant disposé de façon à avoir une surface de croissance correspondant à un côté de Si de la direction d'un axe polaire.
